# EUROPEAN PATENT APPLICATION

(11) **EP 4 166 497 A1**
(43) Date of publication of application: **19.04.2023**
(21) Application number: 21202796.5
(22) Date of filing: 15.10.2021
(51) Int. Cl.: B81B 7/00, H01L 23/544

(54) **ENCLOSURE WITH INFORMATION PATTERN**

(71) Applicant: SCHOTT AG, 55122 Mainz (DE)
(72) Inventor: THOMAS, Dr. Jens Ulrich, 55128 Mainz (DE); MÄÄTTÄNEN, Antti, 33710 Tampere (FI); ROKKA, Petri, 33720 Tampere (FI)
(74) Representative: Blumbach · Zinngrebe Patentanwälte PartG mbB

(57) **Abstract**

An enclosure is shown, comprising at least a first substrate having an outer surface and a second substrate having an outer surface, wherein the first substrate and the second substrate are arranged next to each other in such a way, that an inner surface of the first substrate is adjacent to an inner surface of the second substrate, wherein the second substrate is transparent at least in part and/or at least for a bandwidth of wavelengths, at least one laser weld zone containing an information pattern in the enclosure, wherein the at least one laser weld zone extends from within the first substrate to within the second substrate and permanently joins the first substrate to the second substrate.

## Description

### Field of the invention

The invention is related to an enclosure, for example, for providing a hermetically sealed compartment in at least two layers of substrates, as well as a manufacturing process for making the same.

### Background and Summary of the invention

Enclosures can be used, for example, to protect electronics, circuitry or sensors. It is possible to use hermetically sealed implementations of aforementioned enclosures for medical implants, for example, in a therapy to cure a heart disease, or, for example, in a retina or for any type of bio-processor. Known are bio-processors, which are made from titan.

Sensors can be protected by means of the invention, for example, for use in particular rough climate conditions. Further examples are Micro-Electro-Mechanic-Systems (MEMS), a pressure sensor, blood gas sensor, a glucose meter, such as a blood glucose meter, or the like.

Further fields of usage for the present invention can be found in protection sleeves for cell phones, in the field of virtual reality and augmented reality goggles and headsets and similar devices. For example, the invention may also be used in the scope of electro mobility; But also in aviation and space environment, in high temperature environments and in the field of micro optics the invention might be used.

The aforementioned applications all concern devices faced with rough environmental conditions and which thus have to be designed especially robust - or protected from these conditions. For example, in order to allow for the use of any electronics, which may be expected not to survive the aforementioned environmental conditions, but which may be made cheaper or where even no rough electronics exist which could withstand in this conditions, the invention may be used to protect such devices like electronics.

Especially medical applications like implants require for the device to be uniquely identifiable, both as an anti-counterfeit measure and to enable a full documentation of the whole product life cycle.

Further, the invention may allow to some extent an exchange or way of communication with the inner region of the device according to the invention, e.g., the enclosure, or the cavity situated inside the enclosure. This exchange or way of communication can be realized, e.g., by means of electromagnetic radiation, e.g., in visible light region and/or in the region of microwave radiation. For realization of the same, the enclosure is, at least in part and/or at least for a range of wavelengths, transparent. This transparency allows for communication methods, for any kind of data or energy transmission, and for measurements with and by electronics or sensors situated inside a cavity. In particular, optical communication methods or optical data or energy transmission is possible.

However, implementing a cavity in the enclosure is only an embodiment for possible usages of the invention. As will be understood below, the invention is not limited to enclosures with cavities, but nevertheless it can be used for improving enclosures having cavities.

It is principally known to provide several parts or layers and to arrange them such that in an inner region components can be situated. For example European Patent EP 3 012 059 B1 shows a method for manufacturing a transparent component for protecting an optical component. A new laser welding method is used therein.

The layers to be used can all be glass or glass-like substrates, but it gets increasingly interesting to combine different materials with each other, like metal and glass or epoxy resin, or other silicon-containing materials.

Regarding such enclosures, it was identified as an interesting further development to render a specific enclosure identifiably, or to provide any information accessible from the outside.

Therefore, it is an object of the invention to provide such information in an enclosure, which can be extracted from the enclosure without opening the same or without the need to manipulate or even destroy the enclosure.

It is another object of the invention to enter such information into the enclosure without damaging the outer surface of the enclosure, as it has been found out that such defects or damages in the outer surface may lead to cracks or destruction or influence of light entering or leaving the cavity of the enclosure.

It is yet another object of the invention to provide such an information on a rather small space or area, so that the enclosure can be kept as small as it gets.

Therefore, the present invention may be seen in the vicinity of improving known enclosures, e.g., regarding reliability and/or robustness of enclosures regarding environmental conditions, and improving traceability and/or size of such an enclosure.

The present invention can also been employed in the context of optimizing process chains, especially on wafer and or wafer/chip level: Based on this invention, wafer level information (e.g. bad contact areas or damaged zones on the silicon chip) can be mapped to individual chips. This can be employed for binning after dicing and thus avoiding redundant inspection steps, even if the assembly is spread over several factories.

The object of the invention is achieved by subject matter of the independent claims. Preferred embodiments of the invention are subject of the dependent claims.

An enclosure, according to the invention, comprises at least a first substrate having an outer surface and a second substrate having an outer surface. The first substrate and the second substrate are arranged next to each other in such a way that an inner surface of the first substrate is adjacent to an inner surface of the second substrate. In other words, the two substrates are arranged next to each other, i.e., in direct proximity to one another, wherein the inner surface plane of the first substrate is in contact with the inner surface plane of the second substrate.

Typically, each substrate of the enclosure is comprised rather flat, so that the outer surface as well as the inner surface opposing the outer surface comprise comparably longer dimensions than the circumferential rim, which lies in between the outer surfaces. By aligning several, at least two, substrates next to or above one another, a stack of substrates is formed. Such a stack of substrates may then be laser-welded in order to firmly join the substrates with each other. For example, for each two substrates, one laser weld line may be used for joining these two substrates. Therefore, for example, in the case that four substrates shall be used to form the enclosure, at least three laser weld lines may be introduced, where each laser weld line is arranged such to join the respectively two neighboring substrates of the substrate stack.

The top most substrate, e.g., the second substrate, preferably comprises transparent material and/or is transparent at least in part of its surface or volume and/or at least for a bandwidth of wavelengths. Whenever the laser is used for welding and joining the substrates to each other, the laser therefore can pass through the second substrate in order to e.g. reach the interface zone in between the two substrates to be welded. It is referred to the top-most substrate as the laser is typically shot into the substrate(s) from above. It is clear that reference is made to that substrate through which the laser has to pass in order to arrive at the laser spot where it is intended to be positioned. So in a setup where it is feasible to shoot the laser from the side or from below, then the reference to the "top-most substrate" may no longer be applicable. In any case, it is preferred, that the substrate material (substrate volume) through which the laser travels in order to place the laser spot inside the substrate / substrate stack, comprises transparent material and/or is transparent at least in part of its surface or volume and/or at least for a bandwidth of wavelengths.

The enclosure according to the invention comprises at least one laser weld zone containing an information pattern in the enclosure. The at least one laser weld zone extends from within the first substrate to within the second substrate and permanently joins the first substrate to the second substrate. So in other words, the information pattern(s) firmly join the two substrates positioned close to each other, which is, with the respective inner side in contact with the respective other inner side. The information pattern thus may also, for example, supersede usage of additional laser weld lines and provide for bonding the substrates to each other. The laser weld zone may even be designed to provide hermetical seal to a function zone situated such that it is surrounded by the laser weld zone. But on the other side, also additional laser weld line(s) may be provided to introduce, assure or improve bonding and/or hermetic seal of a function zone.

For example, the laser weld zone could comprise a first separation spacing S1 to the outer surface of the first substrate and a second separation spacing S2 to the outer surface of the second substrate. If separation spacings S1 and S2 are applied, the laser weld zone may be fully enclosed inside the enclosure. This means, in other words, that the laser weld zone is fully enclosed within the enclosure without touching or penetrating either outer surface of the first or second substrate. So to say, the laser weld zone is fully enclosed with material from either the first substrate or the second substrate, or any substrate comprised in the enclosure. The enclosure therefore fully encloses the laser weld zone, which is not in contact with the environment surrounding the enclosure. This does also mean that neither the first outer surface nor the second outer surface, which is the outer surface of the second substrate, is deteriorated by the at least one laser weld zone. This may increase mechanical and/or chemical resistance of the enclosure in comparison with enclosures, where any marking was imposed on the one of the outer sides of the enclosure.

It may also be advantageous if the laser weld zone is initially fully surrounded by material of the enclosure, e.g. including separation spacings S1 and S2, but the enclosure may, e.g. in a later process step, be thinned down so that the laser weld zone is exposed to the surrounding. E.g. the laser weld zone may then also form part of the first outer surface and/or of the second outer surface. Reference is made in this respect, and in particular with respect to methods of polishing down one of the substrates of an enclosure, to German Patent Application DE 10 2020 117 194.3, which is hereby incorporated in its entirety into the present application.

The laser weld zone can be a portion of the first substrate and/or it may be a portion of the second substrate. Preferably, the laser weld zone comprises material from the first substrate as well as material from the second substrate. In other words, material from the first substrate is melted and at the same time material from the second substrate is melted, and the materials are mixed with each other. The information pattern in the laser weld zone typically comprises a refractive index that differs from a refractive index of a normal welded portion of the first and/or second substrate. The information pattern can also be provided as a region of absorption (e.g. Black point or dot). Such a region of absorption may be caused by the shot-to-shot interdistance/pitch, or v/R (where v is the writing velocity and R is the repetition rate of the laser pulses provided by the source). In other words, the information pattern in the laser weld zone is detectable by means of measuring the refractive index, for example, or by measuring transmission, or by visual inspection.

The information pattern of the laser weld zone may be designed to comprise the information in a certain form, such as numbers or letters. Such numbers or letters may be visually visible, so that it can be read simply by optical means, e.g., by an optical readout device, or by the human eye, maybe with the aid of augmentation means, e.g. a microscope or a macro objective. The information pattern in the laser weld zone may also comprise a binary readable information pattern, which may be a series of signs to be interpreted as zeros or ones. In an example, a broken line can be interpreted as such a binary readable information pattern. The information of the information pattern may also be given in a line length modulation, where the length of any segment of a laser weld line contains the information, or at least a part of the information to be stored in the laser weld zone. Further, the information may be stored in a barcode form or encoding, in a line width modulation, in a music sheet modulation, in a quick readout code and/or in a Morse code signal or similar. All the aforementioned forms to store the information in the information pattern of the laser weld zone can also be used in a combination, so that thickness of the laser weld lines can encode one type of information, whereas length of the laser weld line segments can encode another type of information.

The information stored in the information pattern may be made user-readable, e.g., by means of an optical readout, so that it may be readily extracted by optical means or even read by a user. The information stored in the information pattern may also be designed to be readable by means of a handheld device. The enclosure therefore may be scanned by means of the handheld device in order to extract the information from the enclosure.

It may be advantageous to encode the information in the laser weld zone in the information pattern. By means of using a codification or an encoding of the information, it may be possible to further shrink the area or space needed to provide the information in the enclosure. For example, by means of the line width modulation and depending upon the resolution of any readout tool, on a small size several types of information can be provided at the same space, where otherwise a greater space was necessary if letters or numbers would be used. Therefore, any machine-readable information may be provided typically on a smaller area and using less space in the enclosure. Thus, even the whole enclosure may be manufactured smaller.

Encoding of the information in the laser weld zone may be achieved in that a variation of the absorption-spot-distance v/R in between consecutive beam spots of a laser weld zone or laser weld line is applied, where v is the writing velocity and R the repetition rate of the laser source. The writing velocity may be realized in movement of the enclosure against a static laser source, or as the case may be, movement of the laser against a static enclosure. The repetition rate may be designed to be adjustable. By amending v/R a characteristic shape of the laser weld line / information pattern can be achieved, where data or information can be encoded to be retrievable from the enclosure.

Information in the weld line can therefore be encoded by varying the velocity v. It is also possible to vary the interspot distance by altering R. In this respect, the repetition rate is typically fixed. But e.g. by using a so-called "pulse picker" and/or by "switching off a sequence of 1 or more pulses, also R can be altered. The pulse picker can be employed between laser source and focusing optic. It can also be integrated in the laser source, e.g. for an ultrashort laser between seed laser and amplifier.

Furthermore, an information pattern may also be obtained by altering, influencing or just considering heat accumulation of N consecutive and/or overlapping beam spots. In some form of further developing the information encoding in a variation of v/R as explained above, information encoding can also be implemented in integer multiples of N · v / R. This may be particularly interesting when high laser repetition rates are used, for example higher than 200 kHz or even in the MHz-range, where v/R is smaller or in the same order as the spot size. For example, overlapping beam spots are obtained when N is 2 or more. Preferably, N may be 10 or more, may be as high as 50 or more, preferably 100 or more, further preferably 200 or more or even 500 or more. Using MHz laser repetition rate N can get as big as N=5000. For example, N is assumed to be 20000 or less.

Therefore information encoding may be achieved in a variation of N · v / R. For example, an accumulation of sufficient N overlapping beam spots leads to a visible marking, whereas when less beam spots overlap, which is, when N is set smaller than the number of overlapping beamspots necessary for generating a visible marking, no such marking is present. This can be adjusted to generate said information pattern, for example for generating a pattern of markings and non-markings to be interpreted as "1" or "0" respectively. And also more complex shaped markings can be obtained, for example a line may be generated when the number of overlapping beam spots is held high enough to produce visible markings, a line is generated. Thereafter the number of overlapping beamspots may be reduced to a value smaller than N necessary to generate a visible marking and the line will be interrupted, or no line (marking) will be visible.

It is also possible that debris from the absorption zone gets transported to the top region of the melt region. Such "debris"-spots would also carry the longitudinal information induced by the spot-to-spot distance. So in other words, in the absorption zone the optical properties of the material may be amended such, that this material may be optically detectable and part of this material may be transported through the melting region to its top, where it rests during solidifying of the melting zone.

The information stored in enclosure may be provided redundantly. To provide redundant information, for example separate laser weld zones may be provided where, for example, two laser weld zones provide an identical information. Another embodiment, which can be combined or used separately, is to provide for a redundant information in that an information pattern is encoded by means of two different encoding means. For example, one information pattern may at the same time be encoded by line width modulation and by means of line length modulation, where retrieving the information encoded in the line width is redundant to the information retrieved from the line length. Redundancy of information can also be obtained by using an encoding method which provides for redundancy in the encoding process, for example such where the code alphabet is longer than the source alphabet, or a, preferably prefix-free, redundance-optimized encoding like e.g. Huffmann-Encoding.

The enclosure as described herein may comprise a function zone that is circumferentially enclosed in the enclosure. Such a function zone may comprise, for instance, a cavity and/or may comprise one or more devices or components to be enclosed inside the enclosure and thus be protected from the environmental conditions outside the enclosure. The function zone may also comprise some detector means, some microelectronic or mechanical system and/or any micro optics. Even an energy-harvesting device such as a small solar cell may be provided in the function zone. The function zone can consist of a coating, for example situated in between the two substrates or provided on one of the inner sides of the first or second substrate.

The laser weld zone and/or at least one laser weld line can be designed in such a way that it hermetically seals the function zone in the enclosure. For example, a laser weld line may be drawn without gap around the function zone, so that the first substrate is hermetically joined to the second substrate.

The laser weld zone and/or the laser weld line typically comprises a series of laser dots in a sequence. These laser dots may be placed close enough to each other, so that they overlap and thus form a continuous laser weld line. Such a continuous laser weld line produced by a series of laser dots comprises hermetically sealing properties, when it is drawn around the function zone. By means of the laser weld line, the substrates are firmly joined with each other in that the laser weld line melts or mixes the material of the first substrate with material of the second substrate in a "convection zone", in that the laser dot is placed such that the aforementioned mixture of materials is achieved.

But not only the laser weld line may be arranged around said function zone. The laser weld zone comprising the information pattern may be arranged around said function zone, for example circumferentially, around the function zone.

The laser weld zone may also be arranged such that it comprises a third separation spacing S3 to the circumferential rim of the enclosure. In other words, the laser weld zone leaves a secure spacing to the circumferential rim so that also said rim is not interfered by the laser weld zone. This spacing may be called a "tolerance zone". Typically, the enclosure is diced out of a wafer or a waferstack, so that additional spacing in between the laser weld zone and the rim is advantageous in that the information is not destroyed or interfered upon dicing the enclosure out of the waferstack.

The laser weld line directly binds the first and second substrate to each other in the case that the first substrate and the second substrate are positioned directly adjacent each other and the laser weld line is meant to join these two substrates with each other by means of a direct laser induced welding process.

The at least one laser weld zone and/or laser weld line may extend from within the first substrate to within the second substrate and may permanently join the first substrate to the second substrate. This may be provided by either a laser weld line specifically introduced to join the two substrates, or it may also be provided in the laser weld zone, where the information pattern may advantageously be hermetically joining the two substrates with each other and, additionally, provide said information pattern.

The laser weld line and/or the laser weld zone may comprise a mixture of material of the first substrate and the second substrate. The mixture is established during introduction of the laser spot, where convection of the material takes place inside the laser spot, as the material is melted and mixed.

In the laser weld zone and/or laser weld line material from the first substrate may be mixed into the second substrate and vice versa, which is, material from the second substrate may also be mixed into the first substrate.

In the laser weld zone and/or laser weld line a convection zone may be present which is characterized in that material from the first substrate is mixed with material from the second substrate in the convection zone.

The laser weld zone and/or laser weld line typically comprises a height HL in a direction perpendicular to its connecting plane. The laser weld zone and/or laser weld line may be situated with a height HL1 inside the first substrate and with a height HL2 = HL - HL1 inside the second substrate. In other words, the complete laser weld line height HL is situated inside either the first substrate or the second substrate, which means that no additional material or spacing is present in between the first substrate in the second substrate. This indicates that the first substrate is directly bonded and mixed with the second substrate by means of the laser weld process. When the laser weld line is equally reaching into both substrates, HL1 = HL2, but, for example, if the laser weld zone and/or laser weld line is shot deeper into the first substrate, then HL1 is greater than HL2. Still, the sum of HL1 + HL2 preferably sums up to HL.

The at least one laser weld zone and/or laser weld line may circumference the function zone in a distance DF, where the distance may correspond, for example, to the height HL or less. The distance DF may also correspond to double the height HL or less.

The function zone may be arranged on the inner side of the first and/or second substrate. The function zone may also comprise at least one cavity. The cavity may, for example, be arranged in the plane of the first and/or second substrate. By way of example, the cavity may be excavated from the first substrate and/or from the second substrate, for example by means of an abrasive method. In the case that three substrates are used to provide the enclosure, the uppermost and lowermost substrate may also be continuous substrates, where the function zone or cavity is arranged in the plane of the intermediate substrate. For example, the intermediate substrate can comprise holes, which become the cavity, when the three substrates are stacked on one another.

There may at least be one functional component arranged inside the cavity, such as an electronics component, a MEMS or MOEMS.

The present disclosure also provides usage of an enclosure as described above for making a medical implant, a wafer level packaged component, a micro lens compound, a microoptical chip, a pharmaceutical packaging, a sensor such as a LIDAR sensor, or an LED device, to give some examples.

The present disclosure also provides for a method of providing an enclosure, for example, an enclosure as described hereinabove, wherein the enclosure encloses at least a laser weld zone. The method comprises the steps providing a first substrate having an inner surface and an outer surface and a second substrate having an inner surface and an outer surface. It provides aligning the first substrate with its inner surface at the inner surface of the second substrate. In other words, the first substrate is positioned adjacent to the second substrate, and each inner surface should be in contact with each other.

It is further provided laser welding the first substrates to the second substrate by means of introducing at least one laser weld zone in the enclosure. The laser weld zone is welded such that an information pattern is provided, wherein an information is stored in the information pattern.

Moreover, the at least one laser weld zone may comprise a first separation spacing S1 to the outer surface of the first substrate and a second separation spacing S2 to the outer surface of the second substrate, so that the laser weld zone is fully enclosed inside the enclosure and/or fully surrounded by material of the enclosure.

The method as described herein may further comprise laser welding at least one of the laser weld zones by guiding a laser beam from a laser beam source such that the laser weld zone is drawn such that it reaches both into the first substrate and the second substrate, thereby firmly and permanently welding the first substrate to the second substrate.

The method as described herein may further comprise wherein the laser weld zone is drawn by means of a pulsed laser source, so that a continuous or a quasi continuous weld zone is composed from several laser pulses and/or so that spaced apart laser weld dots or patterns can be generated in the enclosure.

The enclosure as defined in the method may be enclosing a function zone and may further be comprising the step hermetically sealing the function zone by means of the laser weld line. A laser weld line may contain an information pattern and thus may be assigned to the laser weld zone. In fact, any laser weld zone may comprise any amount of laser weld lines. Only for means of better distinguishing in between the functional ability of storing information, the wording laser weld zone is used, whereas regarding providing the hermetically joining of the substrates and thus hermetically sealing the function zone, the term laser weld line is used. However, the terms laser weld zone and laser weld line may also be used interchangeable. The laser weld zone may also provide the hermetically sealing function for the function zone, for example, when a laser weld line is drawn in the laser weld zone which is a continuous laser weld line through circumferencing the function zone. The other way around, a laser weld line may be drawn such that it contains an information pattern rendering it part of the laser weld zone in that it comprises an information.

Before the step of hermetically sealing the function zone the method may further comprise the step aligning the two substrates directly at each other such that the first substrate is in direct contact with the second substrate, for example, that at least 25 percent of the area of the inner side of the first substrate is in direct contact with the inner side of the second substrate.

The second substrate may comprise at least in part of its surface or volume and/or at least for a wavelength bandwidth a transparent material.

The description may also provide for an evacuated sealed enclosure made by the method as described hereinabove.

The present disclosure also provides for a method of registering an enclosure, wherein the method comprises providing said enclosure, for example an enclosure as described hereinabove in further details. The enclosure comprises a first substrate and a second substrate and at least one information pattern, wherein said first substrate is in direct contact with the second substrate in that an inner surface of the first substrate is adjacent to an inner surface of the second substrate, and wherein said information is stored in said information pattern. The method further defines reading out said information from said information pattern, and registering said information in a data storage, wherein the information provided in the substrate allows for uniquely identifying said enclosure or several enclosures provided in a common manufacturing process.

In an aspect data can be stored directly in the enclosure, where the data may not be available or stored in another place. For example, any kind of process data of or about the manufacturing process may be directly stored in the enclosure during the manufacturing process, where actual process data such as laser properties or environmental conditions are encoded and inscribed in the enclosure. The data may, for example, be translated or encoded from an alphanumeric string to any form of inscribable encoding, such as discussed or disclosed in the present application. This information may then later be read out and registered.

In another aspect data can be stored indirectly, so that data is first or only stored in another place, such as a database, and may or may not thereafter be inscribed in the enclosure. Data may comprise process data. For example, in this case, it is possible to inscribe an unique identifier in the enclosure and to store the information such as process data in the external place, such as a database, cross-referenced by that unique identifier. For example, an alphanumeric string may be inscribed in the enclosure in encoded form, which then represents said unique identifier.

In fact, any data to be stored and mentioned throughout this application may be referred to as directly stored data, where the data itself is stored (inscribed) in the enclosure, and/or as indirectly stored data, where a unique identifier is stored in the enclosure and the data itself is stored in an external place such as a database together with or linked by the unique identifier, for example in order to register/identify/verify the enclosure.

The present disclosure further provides for a data reading and storage system for performing the method as described before, the system comprising: a data storage, a read-out device connected to the data storage by means of a transfer means to read out information stored in the information pattern of an enclosure, and computational means to process the information and to store said information in the data storage.

The present description further provides a hermetically sealed enclosure comprising at least a first substrate having an outer surface and a second substrate having an outer surface. The first substrate and the second substrate are arranged next to each other in such a way that an inner surface of the first substrate is adjacent to an inner surface of the second substrate. The second substrate is made transparent at least in part (of its volume or surface) and/or at least for a bandwidth of wavelengths. The hermetically sealed enclosure further comprises a function zone that is circumferentially enclosed in the enclosure. Further, it comprises a laser weld line for welding the first substrate to the second substrate, and wherein the laser weld line is designed such to hermetically seal the function zone in the enclosure. The hermetically sealed enclosure further comprises at least one laser weld zone to provide an information pattern in the enclosure. The at least one laser weld zone comprises a first separation spacing S1 to the outer surface of the first substrate and a second separation spacing S2 to the outer surface of the second substrate, so that the laser weld zone is fully enclosed inside the enclosure.

As a material for the first and/or second substrate a variety of materials can be used, e.g., homogeneous glass or monocrystalline silicon, chemically hardened glass, even covered with an optical coating, glass or glasslike material, for example, glass ceramics or crystallines such as crystalline glass. Furthermore, silicone-based substrates can be used, where any of the aforementioned materials can be used in combination with each other.

By means of an example, the laser weld line may be obtained by shooting a short pulsed and focused laser beam (e.g. with repetition rate R) from a laser source into the material with a defined wavelength and energy so that a series of beam spots is placed into the material of the enclosure. The substrates and/or focusing optics are set up such, that the focus of the laser is set farther into the substrate stack than a thickness of that substrate above and next to the intended laser weld line, which is, below the interface. The sample may, during the course of laser irradiation, be translated relatively to the source with a velocity v. The beam spot distance is hence v/R. By placing the beam spots so close together that the resulting melting region at least is in contact with the neighboring melting region, or even overlaps with it, heat accumulation can occur such that a continuous weld line is produced.

In the direction perpendicular to its connecting plane the laser weld line comprises said height HL. The connecting plane is the direction in which the neighboring or consecutive beam spots are set, for example, the contact plane of the inner surfaces of the first and second substrate. Typically, the laser welding is performed from "overhead" perspective, meaning that the substrate stack is positioned, e.g., on a surface, such as a table, and that the laser is shot from above at least through the uppermost substrate layer - or through more than one substrate layers - to the place of the beam focus. The height HL thus is measured in the direction of the laser beam, where the width of the laser weld line is measured perpendicular with respect to the direction of the laser beam.

As introduction of a laser weld line may also introduce stress in certain amounts of material, for example, in the region around the laser weld line, the laser weld zone comprising, for example, a second laser weld line or a laser weld trace may relieve the stress introduced by the first laser weld line. Therefore, the enclosure comprising a laser weld line next to the laser weld zone may comprise an improved mechanical stability.

The invention is described in more detail and in view of preferred embodiments hereinafter. Reference is made to the attached drawings wherein like numerals have been applied to like or similar components.

### Brief Description of the Figures

It is shown in
- Fig. 1: a schematic cross-sectional side view of an enclosure according to the invention,
- Fig. 2: a schematic top view of an enclosure,
- Fig. 3: a schematic top view of another embodiment of an enclosure,
- Fig. 4: a schematic cross-sectional side view of another embodiment of an enclosure,
- Fig. 5: another schematic cross-sectional side view of another embodiment of an enclosure,
- Fig. 6: a cross-sectional detail of an enclosure showing in side view the position of laser weld line and laser weld zone of an enclosure having three substrates,
- Fig. 7: a cross-sectional schematic view of a laser weld line in an enclosure,
- Fig. 8: a top view of a wafer stack before singulation/dicing with several enclosures,
- Fig. 9: a cross-sectional top view of an enclosure showing provisional phase of making laser weld lines and dicing region,
- Fig. 10: embodiments A through F of different possibilities of encoding information in a laser weld line,
- Fig. 11: detail of effect of variation of v, R or v/R, and
- Fig. 12: method of manufacturing an enclosure and gathering data from the same.

### Detailed Description of the Invention

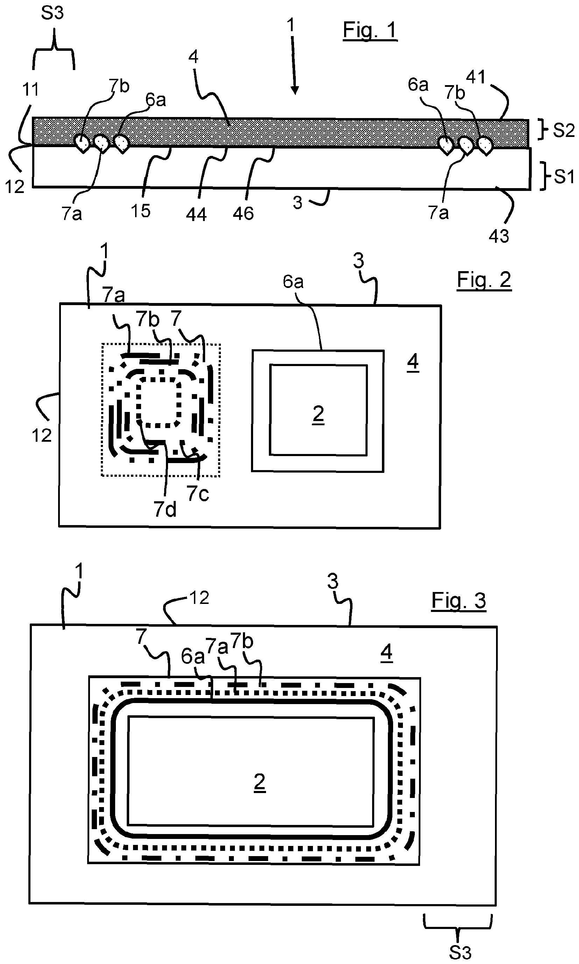

Figure 1 shows a cross-sectional view of an embodiment of an enclosure 1, where a bottom layer 3 is arranged underneath a top layer 4. The bottom layer or first substrate 3 and the top layer or second substrate 4 are hermetically bonded to each other by means of a first laser weld line 6a. The first laser weld line 6a stretches into material of the first substrate 3 as well as into material of the second substrate 4, thus mixing the materials of the two substrates 3, 4. In introducing a firm seal, the first laser weld line 6a may provide a hermetically sealed area, where the first laser weld line 6 a is drawn around such area 2. The two substrates 3, 4 contact each other at the inner side 46 of the first substrate 3 and the inner side 44 of the second substrate 4. Both inner sides 44, 46 touch each other at the contact area 15.

Next to the laser weld line 6a, two laser weld zones 7a, 7b are provided, which may show an information pattern (see other figures). Advantageously, the information zones 7a, 7b are introduced in the same plane as the laser weld line 6a, introduced to hermetically seal the enclosure 1. A laser weld line may also comprise an information pattern and a laser weld zone may, on the other side, comprise the ability of hermetically sealing an area inside the laser weld zone 7a, 7b.

On the side 12 of the enclosure 1, there is the edge 11 of the glass stack, where a spacing S3 is provided in between the edge 11 of the enclosure 1 and the outermost information zone 7b. In the perspective of Figure 1, the rim 12 is orientated vertically, whereas the planes 41, 43, 44 and 46 of the first and second substrates 3, 4 are orientated horizontally. The rim 12 may connect the outer side 41 of the second substrate 4 with the outer side 43 of the first substrate 3, so that the total outer surface area may be comprised by the outer side 41 of the second substrate, the rim 12 and the outer side 43 of the first substrate 3.

The laser weld line 6a as well as the laser weld zone 7a comprising the first information pattern and the second laser weld zone 7b comprising a second information pattern comprise a first separation spacing S1 to the outer surface 43 of the first substrate 3 and a second separation spacing S2 to the outer surface 41 of the second substrate 4. All laser weld lines 6a and laser weld zones 7a, 7b are therefore fully enclosed inside the enclosure. In particular, the laser weld lines 6a and laser weld zones 7a, 7b do not interfere or reach into the outer surfaces 41, 43 of the substrates 3, 4. At the same time, all provided laser weld lines add in joining the two substrates to each other, so that a total joining force may be the sum of the individual joining or binding force of each individual laser weld line / laser weld zone.

For example, the outer surface 43 or the outer surface 41 may be thinned down, e.g. polished, after introduction of the laser weld zones 7a, 7b, so that the first and/or second separation spacing S1, S2 may be reduced or even vanish. As a result, the laser weld zone 7a, 7b can form part of the outer surface 41 and/or outer surface 43. In other words, the laser weld zone 7a may be exposed to the surrounding to be in contact with the surrounding. However, the information pattern as a homogeneous part of the respective substrate, is not more vulnerable or receptive to damage e.g. introduced by chemicals or any kind of weathering. In contrast, it may form part of a planar and polished outer surface 43 or 41 comprising optical properties which distinguish from the surrounding material - and thus allowing for reading out the information stored in the information pattern - but not comprising a substantially differing material compound or geometrical shape.

A laser weld zone 7a may comprise the feature of hermetically joining the two substrates to each other, so that the additional laser weld line 6a may be omitted. This may depend, for example, on the information pattern to be used in the laser weld zone 7a, 7b, where an information pattern with a continuous laser weld trace can comprise the hermetic sealing function, and a discontinuous laser weld trace with spacings between individual laser dots may not or may also comprise a hermetical sealing function. But the laser weld line 6a may also be part of the laser weld zone 7a and may or may not comprise an information pattern.

Referring to Figure 2, a top perspective view of an enclosure 1 is shown, where several laser weld traces 7a, 7b, 7c and 7d are provided in the information zone 7. The information zone 7 may, for example, be arranged in the same plane as depicted in Figure 1 for the laser weld lines, thus at the same time firmly joining the first and second substrates 3, 4 with each other by means of introducing the laser weld lines. Figure 2 shows a separate laser weld zone 7, where, for example, a function zone 2 can be provided next to the information zone 7. In the example of Figure 2, the function zone 2 may or may not be hermetically sealed, depending on whether an additional laser weld line 6a is drawn around the function zone 2. However, it is clear from Figure 2 that the arrangement of the laser weld zone 7 at the side of the function zone 2 necessitates additional spacing in the enclosure 1, as the laser weld zone or information zone 7 is provided separately from the function zone 2. This may, in certain applications, increase readability of the information zone 7, however at the cost of a rather small function zone 2 available inside the enclosure 1 and/or at the cost of a larger overall size of the enclosure 1.

As depicted in Figure 3, the function zone is bigger than that as shown in Figure 2, and additionally, at least the same amount of information may be presented in the information zone 7, which is drawn around the function zone 2. In this case, the function zone 2 may comprise a cavity, where even functional elements 5 can be provided. In this example, a continuous laser weld line 6a is drawn as the innermost line around the function zone 2. Next to the first laser weld line 6a, first and second information pattern 7a, 7b are drawn along the first laser weld line 6a inside the information zone 7. Again, a separation spacing S3 is provided between the information zone 7 and the rim 12 of the enclosure 1.

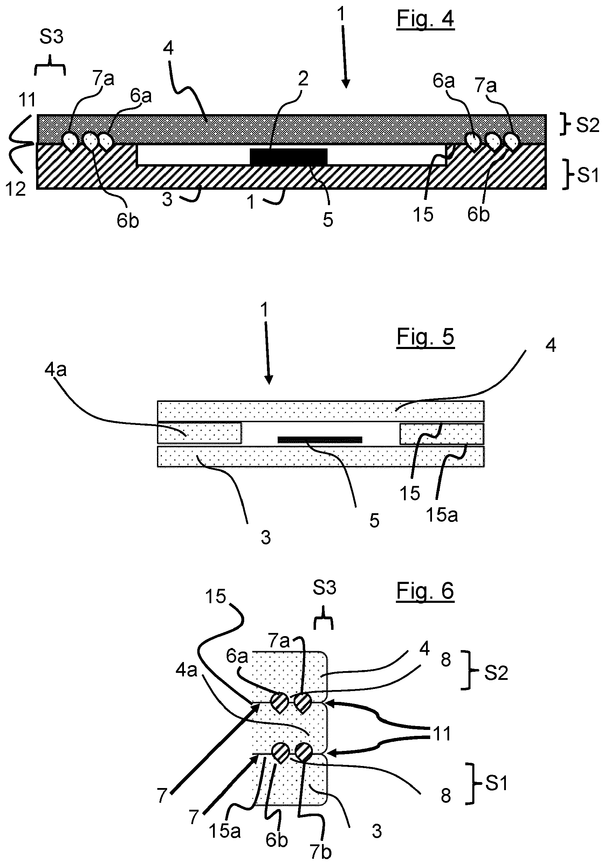

Referring now to Figure 4, enclosure 1 is shown with a cavity 2, which is hermetically sealed by means of a laser weld line 6a which is drawn in the contact area 15 between the first and the second substrates 3, 4. Inside the cavity 2, functional element 5 is arranged, which is hermetically sealed inside the cavity 2. Next to the laser weld line 6a, a second laser weld line 6b is drawn in order to potentially improve hermetically seal of the cavity 2, for example, to provide redundancy in case hermetically seal should degrade over time. Next, a first information pattern 7a is drawn in the information zone 7, which is also arranged in the contact area 15. Hence, depending on the information pattern, another hermetical seal of the cavity 2 may be provided by means of the information pattern 7a. Again, the laser weld lines and laser information pattern comprises first separation spacing S1 to the outer surface 43 of the first substrate 3 and second separation spacing S2 to the outer surface 41 of the second substrate 4. Additionally, a third separation spacing S3 is provided to the rim 12, so that in total all laser weld lines are fully enclosed inside the enclosure. In the example of Figure 4, the cavity is arranged in the plane of the first substrate 3, for example, excavated by means of abrasive methods like sandblasting.

In Figure 5, an embodiment of an enclosure 1 is shown where three substrate layers 3, 4, 4a are used to form the enclosure. Again, the first substrate 3 functions as base layer below the cavity 2, the second substrate 4 functions as a top layer above the cavity 2, and an intermediate layer 4a is arranged in between those two substrates 3 and 4. The first substrate 3 may thus be welded to the intermediate substrate 4a and the second substrate 4 may be welded also to the intermediate substrate 4a by means of two planes of laser weld lines 6a, 6b as shown, for example, in Figure 6. In this example, a first contact area 15 and a second contact area 15a is provided.

Figure 6 shows a detail of an enclosure with three substrates 3, 4, 4a, where a first laser weld line 6a firmly joins the second substrate 4 to the intermediate layer 4a and a second laser weld line 6b firmly joins the first substrate 3 to the intermediate layer 4a. When these two laser weld lines, 6a and 6b, are drawn around a function zone 2, such as in Figure 5, the function zone 2 may be hermetically sealed by means of the laser weld lines 6a and 6b. Next to the laser weld lines 6a, 6b, an information zone 7 is provided and a first and second information pattern 7a, 7b is provided.

By arranging the information patterns 7a, 7b in two different planes, additional formation of the information may be provided, for example in that viewing of the information patterns from the specific angle may interpose the first information pattern 7a with the second information pattern 7b in such a way that both information patterns together provide a single or combined information structure. Thus, it might be said, that the two information patterns 7a, 7b may complement each other so that they contribute to a single information obtained from a certain readout angle of the enclosure 1.

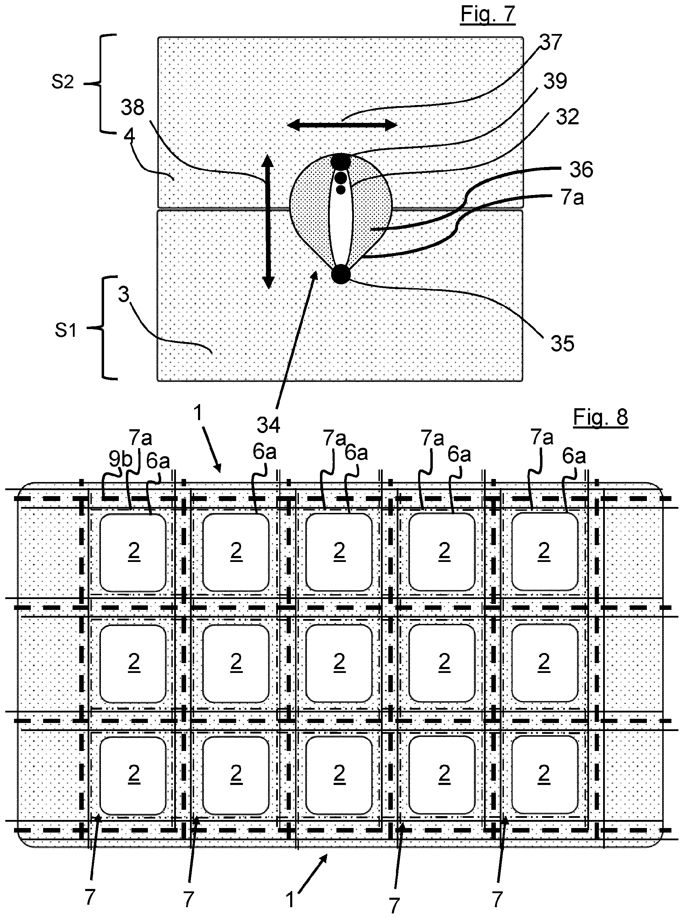

With respect to Figure 7 a cross-sectional detail of a laser weld line is shown in more detail. A single shot of a laser pulse generates a nonlinear absorption. This zone may or may not later be visible as an absorptive volume (e.g. black spot). In the latter the term "nonlinear absorption zone 35" is used to denote the in-situ process volume, where the nonlinear absorption takes place and/or if some permanent modification to the linear absorption has happenden, e.g. cases of visible damage in the substrate. This nonlinear absorption zone 35 can cause heat accumulation, that takes place in the direction towards the laser pulse shot, which is to the above in the plane shown with Figure 7. Several distinguishable areas may be seen in Figure 7 in the laser trace 7a. Above the area of nonlinear absorption 35, which may correspond more or less with the laser focus and which may comprise a size of a few micrometers, an elongated bubble-shaped region 32 may be formed, having only a few micrometers in width but typically up to several tens of micrometer in height (it is also referred to as "bubble" 32 due to its typically quite characteristic shape comparable to an elongated bubble). Around that bubble-shaped region 32 there is situated a melting region 36 with a width indicated with arrow 37 and an height indicated with arrow 38, wherein temperatures above Tg may be reached in the glass, which therefore has resolidified (after cooling or dissipation of warmth). The melting region 36 with the included elongated bubble 32 may usually clearly be identified, for example, with a light microscope, since its density and/or the refractive index has changed with respect to the surrounding material of the respective substrate (e.g. glass). In some cases, the area of nonlinear absorption 35 can also be observed as optical damage on the lower tip of the melting region 36.

Each laser spot and thus each laser weld line 6a, 6b, 6c, 6d may thus be identifiable, for example by optical means, and an information pattern 7, 7a, 7b may be provided inside the glass by providing a laser weld trace 7a with a characteristic shape or width or intensity and so on in order to encode or store information in the laser trace 7a in the information zone 7. One single laser spot may also be referred to as heating zone 34.

Furthermore, in Fig. 7 several small "debris" 39 are shown at the upper side of the melting region 36. Such particles or debris 39 may evade, for example, from the absorption zone 35, or may be made out of material of the first substrate 3 and exchange into the second substrate 4 during melting due to the laser-induced welding process. Such debris 39 may be transported to the top region of the melt region 36 and thus be identifiable, e.g. by optical means and mark the respective laser weld dot. Such "debris"-spots could also carry the longitudinal information induced by the spot-to-spot distance, for example information introduced by varying v / R or N · v / R.

Referring to Figure 8, a multitude of enclosures 1 is provided, each having a cavity 2 inside. Each enclosure 1 comprises a laser weld line 6a circumferencing the function zone 2 and thus hermetically sealing the function zone 2 against the environment or against the other function zones 2. A dicing line 9b is indicated, where dicing off the enclosures 1, which is singulating each enclosure 1, will take place. Between the first laser weld line 6a and the dicing line 9b, an information pattern 7a is provided, arranged around the respective function zone 2. So to say, a multitude of enclosures 1 may be prepared and provided at the same time with the same method step, where each individual enclosure 1 may be provided with individual markings for information in the respective information pattern 7a inscribed with the laser. The laser used to generate the information pattern 7a may be the same as used for introducing the laser weld line 6a into the enclosure 1.

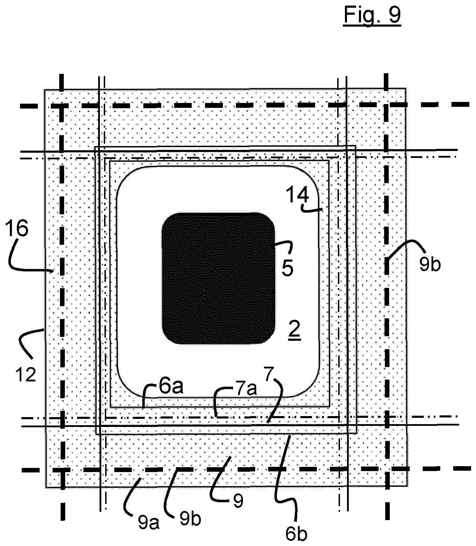

With respect to Figure 9, a detail from Figure 8 is shown, comprising one enclosure and the respective details in higher resolution. Inside the function zone, here a cavity 2, a functional element 5 is situated, which is hermetically sealed by means of the laser weld line 6a. Next to the laser weld line 6a, information zone 7 is provided, wherein a first information pattern 7a is provided and information is stored in said first information pattern 7a.

Information to be stored in the information pattern 7a or in the information zone 7 may be related to any retracing ability, for example, during packaging of chips, especially for enclosures used for medical applications. This may comprise the ability to identify the chip, its manufacturer, its date of fabrication and/ or if it is from a diced wafer, the wafer type and the localization of the chip on the singulated wafer. But additionally, further information can be stored in the information zone 7, in the case of any readable or accessible data storage inside the enclosure 1, for example, information like access, data, e.g., a password, can be stored in the information zone 7.

In general, the information zone 7 may comprise data such as component data, comprising such as one of wafer information, wherein wafer information may comprise the manufacturer, origin, storage time, price, material, geometry, surface heat, local defects, coatings such as non-organic or organic coatings, date, kind and facility of inspection, possible exposure to x-ray or nuclear radiation and/or particle contamination.

Components' data to be stored in the information zone 7 may also comprise information from the spacer wafer or cavity wafer (which is intermediate layer 4a), such as its manufacturer, source material such as wafer properties, tool and process used for creating the cavities such as sandblasting, laser cutting or etching, and/or glues used in manufacturing the enclosure 1, coatings comprised by the intermediate layer 4a, possible exposure to x-ray or nuclear radiation and particle contamination and the like.

In the case that wafers with Through Glass Vias (TGV) components data to be shown in the information zone 7 may also comprise data on the material of the vias, their geometry, position and also tolerances of a single TGV, its ohmic resistance and so on.

Further information to be provided in the information zone 7 may also comprise data about the enclosed component 5 in the function zone 2 and assembly data. This may include at least one of data related to the component 5 to be enclosed in the enclosure 1 such as manufacturer, ID, possible defects. It may include further one of date, place and operator of placement, used glue or solder or for putting the component 5 into the cavity 2, possible damages, cleanroom data, particle contamination, use of process gas or liquid filling, atmospheric data (pressure, temperature, composition). Another type of component and assembly data could comprise surface quality of to be welded interface 15, 15a.

Furthermore, in the information zone 7, information about bonding and micro welding may be provided such as one of the data, place, machine and operator, operational data of laser, coordinates of welding lines on waferstack, such as X, Y and focal position. The bonding and micro welding data can further comprise temperature of machine, atmosphere, chuck, mechanical holder used, optics used for laser welding, laser beam data, operational data of stage access. The bonding and micro welding data can further comprise position of cavity or of a future chip on the wafer 3, 4 and possible defects. It may even comprise possible postproduction information of wafer such as polishing or a chemical toughening.

Regarding the singulated encapsulation information to be stored in the information zone 7 may comprise one of date, place and operator of singulation, post processing of chips such as polishing and grinding, application of additional coatings and/or polymer enclosures.

The Information to be provided in the information zone 7 may also comprise encapsulation lifetime data such as one of shipment, storage, date of sale, customer and/or sensor lock of device. Of particular interest might be that the information zone 7 comprises a unique identifier and the before-mentioned lifetime data is stored at an external medium, where the data is associated to the unique identifier. Data regarding encapsulation lifetime can also provide one of medical date of insurgent, operation data, checkup data, performance and sensor lock of device. Furthermore, data regarding encapsulation disassembly may be provided in the information zone comprising at least one of the full lifetime data of the product and/or counterfeit identification data.

Turning back to Figure 9 next to the information zone 7, a tolerance zone 9 is provided in between the information zone 7 and the to be applied dicing line 9b in the dicing zone 9a. In other words, in order to assure that the information stored in the information zone 7 is not affected or destroyed, when the enclosure is singulated from the waferstack comprising the multitude of enclosures 1 (see Figure 8), a safety spacing is provided by means of the tolerance zone 9 tolerating possible deviations during introduction of the laser weld traces 7a, 7b, 7c, 7d in the information zone 7 and as well taking into account possible deviations or cracks introduced by dicing the enclosure 1 during singulation of the individual enclosures 1. In other words, the tolerance zone 9 assures that information stored in the information zone 7 is safely stored and readily read out after singulation of the enclosure 1.

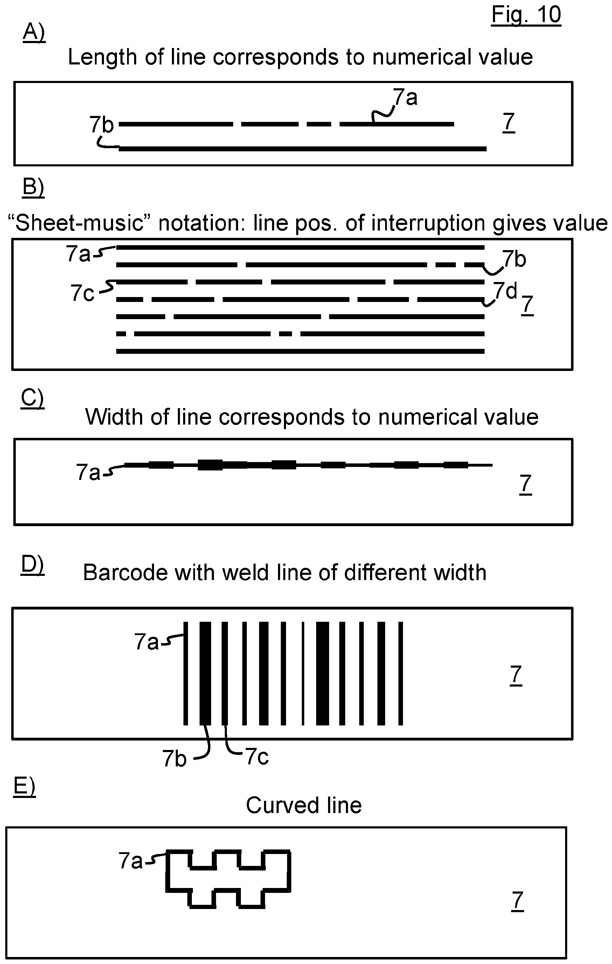

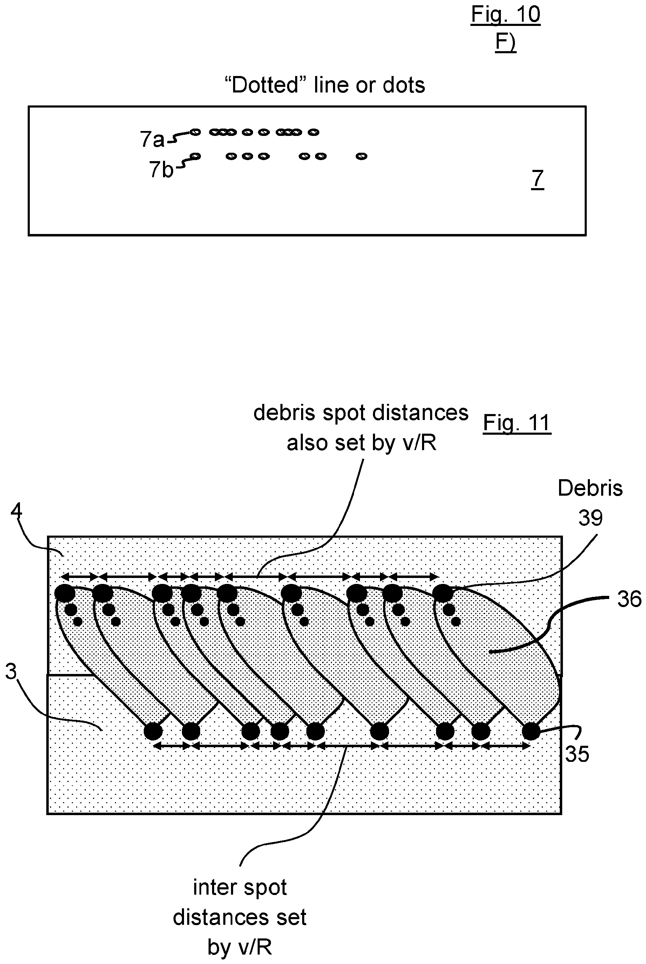

Referring to Figure 10, several embodiments of how to provide the information in the information zone 7 are provided as examples, where it is clear that other markings or form for encoding the information may also be used for this task. Item A of Fig. 10 shows encoding of information in the laser weld trace by means of varying the length of the laser weld traces. In other words, each length piece of the laser weld trace forming a piece of a laser weld line comprises encoded information such as binary readable information or the letters or any form of encoded information.

Item B of Fig. 10 shows another possibility to encode information in the information zone 7, here as a "sheet music notation". The position of interruption of any of the laser weld traces, of which seven are shown in the information zone 7 of item B shown in Fig. 10, indicates a certain information encoding. It may also be possible to superimpose the different options of how to encode the information in the information zone 7 by means of laser weld traces 7a through 7d.

Item C of Figure 10 shows a line width variation of a laser weld trace 7a, wherein the width 37 of the laser weld trace 7a information is encoded. It may be noted that more than two different widths may be used, for example, eight distinguishable widths 37 of the laser weld trace 7a, or less or more than seven or eight. For example, also four different widths 37 may be implemented to encode information in the laser weld trace 7a. Also, several laser weld traces may be superimposed next to each other to generate the optical effect of different widths 37 of the laser weld traces. Another aspect to alter the width of the laser weld trace 7a is to alter the inscription velocity v of the laser, which is, by accelerating or decelerating the welding velocity v.

Item D of Figure 10 shows a barcode-style encoding of information in the information zone showing also weld lines of different width and/or different spacing to each other. In this example, information may be encoded in the spacing in between neighboring laser weld traces 7a, 7b, 7c, 7d and/or may be encoded in the width 37 of each of the laser weld traces 7a, 7b, 7c, 7d and so on.

Regarding Item E of Figure 10, a curved line is shown, so that a continuous laser weld line 6a or 7a can be used and at the same time information be encoded in such a continuous weld line. In particular, Items C and E show embodiments, where the continuous weld line is used, which does not only encode information, but also provides a hermetically sealing function for, for example, the function zone 2 in the cavity.

Regarding Item F of Fig. 10 a "dotted" line or dots are shown, for example as a result of variation of the inscription velocity v, or variation of the interspot distance R, or v/R.

The lines 7a or 7b may be composed by one or several consecutive dots. In line 7a some of the dots may overlap and form short lines, where other dots may not overlap and remain as dots. In line 7b the spacing in between the dots varies and encoding of information can be stored in variation of the dot spacing. Information stored in these dotted lines can be for example binary information (no dot / dot represents 0 or 1) or complex information (line length modulation and so on).

Information in the laser weld zone 7 can therefore also be encoded by varying the velocity v of the inscription laser 50. For example, the movement velocity of a movable table, where the enclosure 1 or the substrate stack 3, 4 is positioned, may be altered during the inscription process in order to vary v.

It is also possible to vary the interspot distance by altering R. In this respect, the repetition rate is typically fixed. But e.g. by using a so-called "pulse picker" and/or by "switching off' a sequence of 1 or more pulses, also R can be altered. The pulse picker can be employed between laser source 50 and focusing optic. It can also be integrated in the laser source 50, e.g. for an ultrashort laser 52 between seed laser and amplifier.

It is also possible that debris from the absorption zone 35 gets transported to the top region of the melt region 36. Such "debris"-spots 39 would also carry the longitudinal information induced by the spot-to-spot distance. So in other words, in the absorption zone 35 the optical properties of the material may be amended such, that this material may be optically detectable and part of this material may be transported through the melting region 36 to its top, where it rests during solidifying of the melting zone. With respect to Fig. 11 alteration of spot distances is shown. By means of varying movement velocity v and/or repetition rate R the inter-spot distance, which is v/R, or N · v / R, may be affected. By setting the inter-spot distance close enough, consecutive bubbles 36 may overlap and a continuous line (at least in between the consecutive bubbles 36) may be generated. If the inter spot distance is increased, the bubbles 36 get separated and may be identified as single dots. This effect may be, alternatively or additionally, be emphasized or noticed if the make of the enclosure 1 is adjusted such that debris 39 occur. Then the spacing in between debris 39 may be detected, so that, as the case may be, the laser dots may be placed even closer to each other. A "debris spot distance" can therefore be obtained, corresponding to the distance between the consecutive points of nonlinear absorption 35. Therefore, a more compact way of providing readable information is provided, so that an even higher data density (and/or smaller area for the laser weld zone 7) may be retrieved.

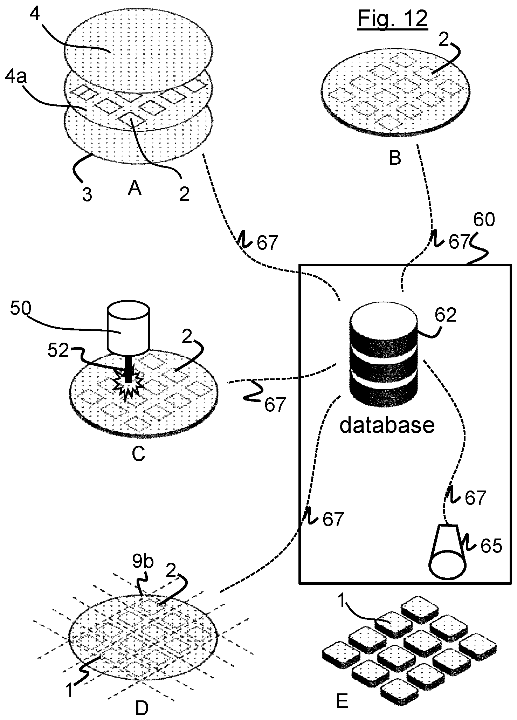

Referring to Figure 12, method steps of the method of manufacturing an enclosure 1 according to the invention are disclosed. When referring to data to be stored, direct storage in the information zone and/or indirect storage via inscribing a unique identifier into the information zone may be included. In indirect storage storing of the corresponding information data in an external database may be performed, wherein the unique identifier stored in the enclosure is additionally stored or linked as a reference, for example in order to register/identify/verify the enclosure. In Step A, the substrates are aligned on top of each other, in this example wafers 3, 4, 4a are used, wherein in the wafer 4a openings are provided, which will later form cavities 2 of the respective enclosure 1. A to be sealed component 5 is arranged in Step A in each enclosure 1, if applicable. Data may be stored in the information zone 7 of the enclosure about Step A, for example, related to component data, regarding wafer, spacer and enclosed component 5, data related to placement, component soldering or gluing.

In Step B as shown in Figure 12, the wafers are stacked above each other in order to generate a waferstack, wherein several enclosures 1 will be obtained. The wafers 3, 4a, 4 may be optically aligned on top of each other. Data to be stored in the information zone 7 of the respective enclosure 1 out of Step B may comprise data related to contact bonding, such as the obtained bond quality index prior to laser welding the enclosures. In this regard, and in particular regarding said bond quality index, reference is made to German Patent Application DE 10 2020 129 220.1 which is incorporated herewith in its entirety to the present application.

For example, a Bond Quality Index Q₁ is obtained when Q₁ = 1 - (A - G) / A. Herein, A corresponds to the contact area 15, 15a between each two substrates or wafers 3, 4, 4a. G corresponds to the area, wherein the a possibly remaining separation or spacing (e.g. due to remaining particles or unevenness of the substrates) in between the two substrates 3, 4, 4a, and in the contact area 15, 15a is smaller than a predefined value P. This value P corresponds to, e.g., a separation in between the two substrates 3, 4, 4a of 5 µm or less, preferably 2 µm or less, further preferably 1 µm or less. In other words, the Bond Quality Index Q₁ describes the percentage of the contact area 15, 15a where separation between the two neighboring substrates 3, 4, 4a is less than P. It is further preferred to establish a first Bond Quality Index Q₁ before laser welding the wafer stack and a second Bond Quality Index Q₂ after laser welding the wafer stack. Although it is possible to bridge possible gaps (separation) between two neighboring substrates 3, 4, 4a with the laser weld line and nevertheless obtain a solid and resilient connection between the welded substrates 3, 4, 4a, it has been found out that residual strain may result in one or both substrates 3, 4, 4a after welding, if such a separation was bridged by the laser weld line. These residual strain in the substrate may even show a characteristic in that it is not measurable in the later product, or may only be measured with a high effort. This may result in premature wear or failure. By means of comparing Q₁ with Q₂ it is possible to estimate residual tension and/or possible shortage on lifetime of the enclosure 1.

Step C of the method shown in Figure 12 comprises laser welding each cavity of the wafers 3, 4a, 4 and encoding of information in the laser information zone 7, such as date, welding ID or cavity ID, wafer ID, chip position on wafer. Further information which might be stored in the information zone 7 could comprise the machine used for laser welding, any laser data, position of weld lines and so on. Any defaults that can be measured on a wafer level inspection tool (e.g. defective weld lines, enclosed particles) can now also be mapped to the uniquely identified chips.

Step D as shown in Figure 12 comprises separation or dicing, respectively, of the waferstack and thus singulating the several enclosures out of the waferstack. Information to be stored in the information zone 7 of the respective cavity may comprise the bond quality index obtained after laser welding, data on postprocessing of waferstack or data related to separation or dicing of the waferstack. All of this data can be used for cost effective binning of the devices: depending on a set quality criteria, the singulated chips can be sorted solely by their unique identifier, without having to resort to additional inspection steps.

Step E as shown in Figure 12 shows obtaining the simulated enclosures 1, where additional data to be storage in the information zone 7 may comprise information of additional fabrication steps as well as the lifetime data linked to each enclosure with its unique ID number.

All dimension data mentioned hereinabove in the specification may be read out, for example, by optical means or by a handheld device and be stored in the database 62 shown in Figure 12, which is part of a computer device 60. For example, the data may be read from the information zone 7 by means of handheld device 65 and transferred to the database 62 by any transfer means 67. Transfer means may include cable or wireless communication. The readout device 65 can also be any optical device or simply human's eye in order to extract the information stored in the information zone 7 of the respective enclosure 1.

It will be appreciated that the features defined herein in accordance with any aspect of the present invention or in relation to any specific embodiment of the invention may be utilized, either alone or in combination with any other feature or aspect of the invention or embodiment. In particular, the present invention is intended to cover an enclosure 1 and/or a method of manufacturing an enclosure 1 configured to include any feature described herein. It will be generally appreciated that any feature disclosed herein may be an essential feature of the invention alone, even if disclosed in combination with other features, irrespective of whether disclosed in the description, the claims and/or the drawings.

It will be further appreciated that the above-described embodiments of the invention have been set forth solely by way of example and illustration of the principles thereof and that further modifications and alterations may be made therein without thereby departing from the scope of the invention.

### Reference list:

- 1: enclosure
- 2: function zone or cavity
- 3: first substrate
- 4: second substrate
- 4a: further substrate, like intermediate substrate
- 5: functional element
- 6a: first laser weld line
- 6b: second laser weld line
- 7: laser weld zone or information zone
- 7a: first information pattern or laser weld trace
- 7b: second information pattern or laser weld trace
- 7c: third information pattern or laser weld trace
- 7d: fourth information pattern or laser weld trace
- 8: interface zone or bonded/mixed material area
- 9: tolerance zone
- 9a: dicing zone
- 9b: dicing line
- 11: edge of glass stack / enclosure
- 12: rim
- 14: spacing between laser weld zone and cavity/function zone
- 15: contact area
- 15a: second contact area
- 16: spacing to edge 11 or rim 12
- 32: elongated bubble
- 34: Heating zone
- 35: Area of nonlinear absorption
- 36: Melting region
- 37: lateral width of laser weld line or zone
- 38: vertical height of laser weld line or zone
- 39: debris or particles, e.g. from focus point (area of nonlinear absorption)
- 41: outer side of second substrate
- 43: outer side of first substrate
- 44: inner side of second substrate
- 46: inner side of first substrate
- 50: welding laser generator
- 52: welding laser beam
- 60: computer device
- 62: database
- 65: readout device
- 67: transfer means

## Claims

1. An enclosure (1), comprising:
at least a first substrate (3) and a second substrate (4, 4a),
wherein the first substrate and the second substrate are arranged next to each other in such a way, that an inner surface (46) of the first substrate is adjacent to an inner surface (44) of the second substrate,
wherein the second substrate is transparent at least in part and/or at least for a bandwidth of wavelengths,
at least one laser weld zone (7) containing an information pattern (7a, 7b, 7c, 7d) in the enclosure,
wherein the information pattern of the at least one laser weld zone extends from within the first substrate to within the second substrate and permanently joins the first substrate to the second substrate.

2. The enclosure (1) according to the preceding claim,
wherein the first substrate (3) comprises an outer surface (43) and wherein the second substrate comprises an outer surface (41), and
wherein the at least one laser weld zone comprises a first separation spacing S1 to the outer surface of the first substrate and a second separation spacing S2 to the outer surface of the second substrate.

3. The enclosure (1) according to any of the preceding claims, wherein the laser weld zone (7) is a portion of the first and/or second substrate (3, 4a, 4) having a refractive index that differs from a refractive index of a non-welded portion of the first and/or second substrate.

4. The enclosure (1) according to any of the preceding claims, wherein the information pattern (7a, 7b, 7c, 7d) is designed to comprise at least one of the following:
a unique identifier,
numbers or letters,
a binary readable information pattern,
line length modulation,
barcode form or encoding,
line width modulation,
music sheet modulation,
Quick Readout code,
morse code signal or similar.

5. The enclosure (1) according to any of the preceding claims,
wherein the information stored in the information pattern (7a, 7b, 7c, 7d) is user-readable, e.g. by means of an optical readout, and/or
wherein the information stored in the information pattern (7a, 7b, 7c, 7d) is designed to be readable by means of a handheld device (65).

6. The enclosure (1) according to any of the preceding claims,
wherein the information stored in the information pattern (7a, 7b, 7c, 7d) is designed to be read out and stored in a database (62).

7. The enclosure (1) according to any of the preceding claims,
wherein information in the laser weld zone (7) is encoded in the information pattern (7a, 7b, 7c, 7d).

8. The enclosure (1) according to the preceding claim,
wherein encoding of the information in the laser weld zone (7) is achieved in that a variation of the absorption-spot-distance v/R in between consecutive beam spots of a laser weld zone or laser weld line is applied, and/or
wherein encoding of the information in the laser weld zone (7) is achieved in that a variation of the number N of overlapping beam spots in the absorption-spot-distance v/R is applied, wherein N is 2 or more, preferably 10 or more, further preferably 50 or more, and wheren N is 20000 or less.

9. The enclosure (1) according to any of the preceding claims, further comprising a function zone (2) that is circumferentially enclosed in the enclosure.

10. Hermetically sealed enclosure (1) according to the preceding claim,
wherein the laser weld zone (7) and/or at least one laser weld line (6a, 6b) is designed such to hermetically seal the function zone (2) in the enclosure.

11. Enclosure (1) according to any of the preceding claims,
wherein the laser weld zone (7) and/or the laser weld line (6a, 6b) comprises a series of laser dots in a sequence.

12. Enclosure (1) according to any of the three preceding claims,
wherein the laser weld zone (7) is arranged around said function zone (2), for example circumferentially around said function zone, and/or
wherein the laser weld zone (7) is arranged such, that it comprises a third separation spacing S3 to the circumferential rim (12) of the enclosure.

13. Enclosure (1) according to any of the preceding claims,
wherein the laser weld line (6a, 6b) directly binds the first and second substrate (3, 4a, 4) to each other by means of a direct laser-induced welding process, and/or
the at least one laser weld zone (7) and/or laser weld line (6a, 6b) extends from within the first substrate (3) to within the second substrate (4, 4a) and permanently joins the first substrate to the second substrate.

14. Enclosure (1) according to any of the preceding claims,
wherein the laser weld zone (7) and/or laser weld line (6a, 6b) comprises a mixture of material of the first substrate (3) and the second substrate (4, 4a), and/or
wherein in the laser weld zone (7) and/or laser weld line (6a, 6b) material from the first substrate (3) is mixed into the second substrate (4, 4a) and/or material from the second substrate is mixed into the first substrate, and/or
wherein in the laser weld zone (7) and/or laser weld line (6a, 6b) a convection zone (36) is present, where material from the first substrate (3) is mixed with material from the second substrate (4, 4a).

15. Enclosure (1) according to any of the preceding claims,
wherein the laser weld zone (7) and/or laser weld line (6a, 6b) comprises a height HL in a direction perpendicular to its connecting plane, and
wherein the laser weld zone (7) and/or laser weld line (6a, 6b) is situated with a height HL1 inside the first substrate (3) and with a height HL2 = HL - HL1 inside the second substrate (4, 4a).

16. Enclosure (1) according to any of the preceding claims,
wherein the at least one laser weld zone (7) and/or laser weld line (6a, 6b) circumferences the function zone (2) in a distance DF, where the distance corresponds, for example, to the height HL or less, or corresponds to double the height HL or less.

17. Enclosure (1) according to any of the preceding claims,
wherein the function zone (2) is arranged on the inner side (44, 46) of the first and/or second substrate (3, 4a, 4), and/or
wherein the function zone (2) comprises at least one cavity.

18. Enclosure (1) according to the preceding claim,
wherein at least one functional component (5) is arranged in said cavity (2), such as an electronics component, a MEMS or a MOEMS, and/or
wherein a fluid, such as a gas, is encapsulated in said cavity (2).

19. Use of an enclosure (1) according to one of the preceding claims for making a medical implant, a wafer level packaged component, micro lens compound, a micro optical chip, a pharma packaging, a sensor such as a LIDAR sensor, or an LED device.

20. Method of providing an enclosure (1), for example as claimed in any of the preceding claims, wherein the enclosure encloses a laser weld zone (7), the method comprising the steps:
providing a first substrate (3) having an inner surface (46) and an outer surface (43) and a second substrate (4, 4a) having an inner surface (44) and an outer surface (41),
aligning the first substrate with the inner surface at the inner surface of the second substrate,
laser welding the first substrate to the second substrate by means of introducing at least one laser weld zone (7) in the enclosure,
wherein the laser weld zone is welded such that an information pattern (7a, 7b, 7c, 7d) is provided, wherein an information is stored in the information pattern,
wherein the at least one laser weld zone comprises a first separation spacing S1 to the outer surface of the first substrate and a second separation spacing S2 to the outer surface of the second substrate, so that the laser weld zone is fully enclosed inside the enclosure.

21. The method of providing an enclosure (1) as claimed in the preceding claim, wherein the laser welding step comprises:
laser welding at least one of the laser weld zones (7) by guiding a laser beam (52) from a laser beam source (50) such that the laser weld zone is drawn such that it reaches both into the first substrate (3) and the second substrate (4, 4a), thereby firmly and permanently welding the first substrate to the second substrate.

22. The method of providing an enclosure (1) as claimed in any of the preceding method claims, wherein the laser weld zone (7) is drawn by means of a pulsed laser source (50), so that a continuous or a quasi-continuous weld zone is composed from several laser pulses and/or so that spaced apart laser weld dots or patterns can be generated in the enclosure.

23. The method of providing an enclosure (1) as claimed in any of the preceding method claims,
the enclosure further enclosing a function zone (2), and the method further comprising the step
hermetically sealing the function zone by means of a laser weld line (6a, 6b).

24. The method of providing an enclosure (1) as claimed in any of the preceding method claims, before the step of hermetically sealing the function zone further comprising the step
aligning the at least two substrates (3, 4a, 4) directly at each other such that the first substrate is in direct contact with the second substrate, for example, that at least 25 percent of the area of the inner side (46) of the first substrate is in direct contact with the inner side (44) of the second substrate.

25. The method of providing an enclosure (1) as claimed in any of the preceding method claims, wherein the second substrate (4, 4a) comprises at least in part and/or at least for a wavelength bandwidth a transparent material.

26. Evacuated sealed enclosure (1) made by the method as claimed in any of the preceding method claims.

27. Method of registering an enclosure (1), comprising:
providing said enclosure, the enclosure comprising a first substrate (3) and a second substrate (4, 4a) and at least one information pattern (7a, 7b, 7c, 7d), wherein said first substrate is in direct contact with the second substrate in that an inner surface (46) of the first substrate is adjacent to an inner surface (44) of the second substrate, and wherein said information is stored in said information pattern,
reading out said information from said information pattern,
registering said information in a data storage (62),
storing additional information related to said information in a data storage (62),
wherein the information provided in the substrate allows for uniquely identifying said enclosure or several enclosures provided in a common manufacturing process.

28. Data reading and storage system (60) for performing the method as defined in the preceding claim, the system comprising:
a data storage (62)
a read-out device (65) connected to the data storage by means of a transfer means (67) to read out information stored in the information pattern (7a, 7b, 7c, 7d) of an enclosure (1),
computational means to process the information and to store said information in the data storage.

29. An enclosure (1), comprising:
at least a first substrate (3) having an outer surface (43) and
a second outer surface (41),
at least one laser weld zone (7) containing an information pattern (7a, 7b, 7c, 7d) in the enclosure,
wherein the at least one laser weld zone comprises a first separation spacing S1 to the outer surface of the first substrate and a second separation spacing S2 to the second outer surface, so that the laser weld zone is fully enclosed inside the enclosure.

30. An enclosure (1), comprising:
at least a first substrate (3), and
at least one information pattern (7a, 7b, 7c, 7d), wherein an information is encoded in said information pattern,
wherein encoding of the information is achieved by means of at least one of the following encoding types:
a binary readable information pattern,
line length modulation,
barcode form or encoding,
line width modulation,
music sheet modulation,
Quick Readout code,
morse code signal, or
a variation of the absorption-spot-distance v/R in between consecutive beam spots.
